# EUROPÄISCHE PATENTSCHRIFT

(11) **EP 2 824 837 B1**
(45) Veröffentlichungstag und Bekanntmachung des Hinweises auf die Patenterteilung: **20.04.2016**
(21) Anmeldenummer: 14165369.1
(22) Anmeldetag: 22.04.2014
(51) Int. Cl.: H03K 17/12, H02M 1/088, H03K 17/16

(54) **Leistungshalbleiterschaltung**
Power semiconductor switch circuit
Commutateur semi-conducteur de puissance

(30) Priorität: 09.07.2013 DE 102013107239
(43) Veröffentlichungstag der Anmeldung: 14.01.2015
(73) Patentinhaber: SEMIKRON Elektronik GmbH & Co. KG, 90431 Nürnberg (DE)
(72) Erfinder: Mühlhöfer, Alexander, 90522 Oberasbach (DE); Schmidt, Jürgen, 91077 Ermreuth (DE)

(56) Entgegenhaltungen:
- EP-A1- 1 168 620
- EP-A2- 0 818 889
- EP-A2- 2 164 157
- EP-A2- 2 597 767
- DE-A1- 19 726 765
- US-A- 5 057 719

## Beschreibung

Die Erfindung betrifft eine Leistungshalbleiterschaltung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Bei hohen Lastströmen ist es dabei oft erforderlich, wenn die Stromtragefähigkeit eines einzelnen Leistungshalbleiterschalters nicht ausreichend ist, mehrere Leistungshalbleiterschalter elektrisch parallel zu schalten und diese gemeinsam anzusteuern, so dass diese zusammen einen Hochleistungshalbleiterschalter bilden. Dabei sollen möglichst alle parallel geschalteten Leistungshalbleiterschalter zeitsynchron ein- und ausschalten um eine gleichmäßige Stromaufteilung auf die elektrisch parallel geschalteten Leistungshalbleiterschalter zu erzielen.

Nachteilig bei einem solchen Vorgehen ist, dass, z.B. aufgrund von Bauteiltoleranzen und unterschiedlicher parasitärer Induktivität der Zuleitungen zu den elektrisch parallel geschalteten Leistungshalbleiterschaltern, es zu unterschiedlichen Ein- und Ausschaltzeitpunkten der elektrisch parallel geschalteten Leistungshalbleiterschalter kommt. Die unterschiedlichen Ein- und Ausschaltzeitpunkte führen zu elektrischen Potentialverschiebungen an den Emittern der elektrisch parallel geschalteten Leistungshalbleiterschaltern, so dass sich die elektrisch parallel geschalteten Leistungshalbleiterschalter gegenseitig in Ihrem Schaltverhalten beeinflussen, was zu einer ungleichmäßigen Stromaufteilung zwischen den elektrisch parallel geschalteten Leistungshalbleiterschaltern führt.

Zur Lösung dieser Problematik ist es aus der EP 1625 660 B1 bekannt bei allen elektrisch parallel geschalteten Leistungshalbleiterschaltern zwischen der Ansteuereinheit, welche die elektrisch parallel geschalteten Leistungshalbleiterschalter ansteuert und den elektrisch parallel geschalteten Leistungshalbleiterschaltern jeweilig eine Gleichtaktdrossel vorzusehen, die in der EP 1625 660 B1 als Gleichtaktunterdrückungsdrossel bezeichnet wird.

Nachteilig bei der in der EP 1625 660 B1 vorgeschlagen Lösung ist, dass aufgrund der Potentialverschiebungen an den Emittern der elektrisch parallel geschalteten Leistungshalbleiterschaltern zwischen den Emittern der Leistungshalbleiterschalter über die Gleichtaktdrosseln Ausgleichströme fließen, die zu einer magnetischen Sättigung der Gleichtaktdrosseln führen können, so dass die Gleichtaktdrosseln dann keine bzw. nur noch eine stark reduzierte Wirkung haben.

Eine andere Leistungshalbleiterschaltung mit elektrisch parallel geschalteten Leistungshalbleiterschaltern ist aus der EP0818889 benannt. Es ist Aufgabe der Erfindung eine Leistungshalbleiterschaltung zu schaffen, bei der eine möglichst gleichmäßige Stromaufteilung zwischen den elektrisch parallel geschalteten Leistungshalbleiterschaltern der Leistungshalbleiterschaltung erzielt wird. Diese Aufgabe wird gelöst durch eine Leistungshalbleiterschaltung aufweisend,
- mindestens zwei elektrisch parallel geschaltete Leistungshalbleiterschalter, die jeweilig einen ersten und einen zweiten Laststromanschluss und einen Steueranschluss aufweisen, wobei die ersten Laststromanschlüsse der Leistungshalbleiterschalter elektrisch leitend miteinander verbunden sind und die zweiten Laststromanschlüsse der Leistungshalbleiterschalter elektrisch leitend miteinander verbunden sind,
- eine Ansteuerbeschaltung, wobei die Ansteuerbeschaltung einen ersten, zweiten, dritten und einen vierten elektrischen Anschlusspunkt aufweist, wobei der erste und dritte Anschlusspunkt elektrisch mit den Steueranschlüssen der Leistungshalbleiterschalter verbunden ist und der zweite und vierte Anschlusspunkt elektrisch mit den zweiten Laststromanschlüssen der Leistungshalbleiterschalter verbunden ist, wobei elektrisch zwischen dem ersten Anschlusspunkt und den Steueranschlüssen der Leistungshalbleiterschalter jeweilig eine erste Diode, deren Anode dem ersten Anschlusspunkt elektrisch zugewandt ist, geschaltet ist, wobei elektrisch zwischen dem zweiten Anschlusspunkt und den zweiten Laststromanschlüssen der Leistungshalbleiterschalter jeweilig eine zweite Diode, deren Kathode dem zweiten Anschlusspunkt elektrisch zugewandt ist, geschaltet ist, wobei elektrisch zwischen dem dritten Anschlusspunkt und den Steueranschlüssen der Leistungshalbleiterschalter jeweilig eine dritte Diode, deren Kathode dem dritten Anschlusspunkt elektrisch zugewandt ist, geschaltet ist, wobei elektrisch zwischen dem vierten Anschlusspunkt und den zweiten Laststromanschlüssen der Leistungshalbleiterschalter jeweilig eine vierte Diode, deren Anode dem vierten Anschlusspunkt elektrisch zugewandt ist, geschaltet ist, und
- eine Ansteuerschaltung, wobei die Ansteuerschaltung, derart ausgebildet ist, dass die Ansteuerschaltung zum Einschalten der Leistungshalbleiterschalter zwischen dem ersten und zweiten Anschlusspunkt eine erste elektrische Potentialdifferenz und zum Ausschalten der Leistungshalbleiterschalter zwischen dem dritten und vierten Anschlusspunkt eine zweite elektrische Potentialdifferenz erzeugt.

Vorteilhafte Ausbildungen der Erfindung ergeben sich aus den abhängigen Ansprüchen.

Es erweist sich als vorteilhaft, wenn die Ansteuerschaltung bezogen auf eine elektrische Masse der Leistungshalbleiterschaltung eine positive und eine negative elektrische Spannung erzeugt, wobei die Ansteuerschaltung derart ausgebildet ist, dass die Ansteuerschaltung zum Einschalten der Leistungshalbleiterschalter die positive elektrische Spannung auf den ersten Anschlusspunkt der Ansteuerbeschaltung aufschaltet und den zweiten Anschlusspunkt der Ansteuerbeschaltung elektrisch mit der Masse der Leistungshalbleiterschaltung verbindet und die negative elektrische Spannung vom dritten Anschlusspunkt wegschaltet und den vierten Anschlusspunkt der Ansteuerbeschaltung elektrisch von der elektrischen Masse der Leistungshalbleiterschaltung trennt, wobei die Ansteuerschaltung derart ausgebildet ist, dass die Ansteuerschaltung zum Ausschalten der Leistungshalbleiterschalter die negative elektrische Spannung auf den dritten Anschlusspunkt der Ansteuerbeschaltung aufschaltet und den vierten Anschlusspunkt der Ansteuerbeschaltung elektrisch mit der elektrischen Masse der Leistungshalbleiterschaltung verbindet und die positive elektrische Spannung vom ersten Anschlusspunkt wegschaltet und den zweiten Anschlusspunkt der Ansteuerbeschaltung elektrisch von der elektrischen Masse der Leistungshalbleiterschaltung trennt. Die Ansteuerschaltung ist solchermaßen besonders einfach aufgebaut.

Weiterhin erweist es sich als vorteilhaft, wenn die Ansteuerschaltung bezogen auf eine elektrische Masse der Leistungshalbleiterschaltung eine erste positive und eine zweite positive elektrische Spannung erzeugt, wobei die Ansteuerschaltung derart ausgebildet ist, dass die Ansteuerschaltung zum Einschalten der Leistungshalbleiterschalter die erste positive elektrische Spannung auf den ersten Anschlusspunkt der Ansteuerbeschaltung aufschaltet und den zweiten Anschlusspunkt der Ansteuerbeschaltung elektrisch mit der Masse der Leistungshalbleiterschaltung verbindet und die zweite positive elektrische Spannung vom vierten Anschlusspunkt wegschaltet und den dritten Anschlusspunkt der Ansteuerbeschaltung elektrisch von der elektrischen Masse der Leistungshalbleiterschaltung trennt,
wobei die Ansteuerschaltung derart ausgebildet ist, dass die Ansteuerschaltung zum Ausschalten der Leistungshalbleiterschalter die zweite positive elektrische Spannung auf den vierten Anschlusspunkt der Ansteuerbeschaltung aufschaltet und den dritten Anschlusspunkt der Ansteuerbeschaltung elektrisch mit der elektrischen Masse der Leistungshalbleiterschaltung verbindet und die erste positive elektrische Spannung vom ersten Anschlusspunkt wegschaltet und den zweiten Anschlusspunkt der Ansteuerbeschaltung elektrisch von der elektrischen Masse der Leistungshalbleiterschaltung trennt. Die Ansteuerschaltung ist solchermaßen besonders einfach aufgebaut.

Es erweist sich als vorteilhaft, wenn zur jeweiligen ersten Diode ein erster elektrischer Widerstand elektrisch in Reihe geschaltet ist. Durch entsprechende Wahl des Widerstandswerts des ersten elektrischen Widerstands kann die Einschaltgeschwindigkeit der Leistungshalbleiterschalter an die konkreten Erfordernisse der jeweiligen Anwendung der Leistungshalbleiterschaltung angepasst werden.

Weiterhin erweist es sich als vorteilhaft, wenn zur jeweiligen dritten Diode ein dritter elektrischer Widerstand elektrisch in Reihe geschaltet ist. Durch entsprechende Wahl des Widerstandswerts des dritten elektrischen Widerstands kann die Ausschaltgeschwindigkeit der Leistungshalbleiterschalter an die konkreten Erfordernisse der jeweiligen Anwendung der Leistungshalbleiterschaltung angepasst werden.

Weiterhin erweist es sich als vorteilhaft, wenn zur jeweiligen zweiten Diode ein zweiter elektrischer Widerstand elektrisch in Reihe geschaltet ist, da hierdurch die durch die zweiten Dioden fließenden Ströme begrenzt werden und die zweiten Dioden somit vor Überströmen geschützt werden.

Ferner erweist es sich als vorteilhaft, wenn zur jeweiligen vierten Diode ein vierter elektrischer Widerstand elektrisch in Reihe geschaltet ist, da hierdurch, die durch die vierten Dioden fließenden Ströme begrenzt werden und die vierten Dioden somit vor Überströmen geschützt werden.

Weiterhin erweist es sich als vorteilhaft, wenn elektrisch zwischen der ersten, zweiten, dritten und vierten Diode und dem jeweiligen Leistungshalbleiterschalter eine Gleichtaktdrossel geschaltet ist, wobei die Gleichtaktdrossel eine erste Wicklung und eine mit der ersten Wicklung magnetisch gekoppelte zweite Wicklung aufweist, wobei die erste Wicklung elektrisch zwischen den Steueranschluss des jeweiligen Leistungshalbleiterschalters und der Kathode der ersten Diode und der Anode der dritten Diode geschaltet ist, und die zweite Wicklung elektrisch zwischen dem zweiten Laststromanschluss des jeweiligen Leistungshalbleiterschalters und der Anode der zweiten Diode und der Kathode der vierten Diode geschaltet ist. Hierdurch wird die elektrische Spannung, welche über der ersten, zweiten, dritten und/oder vierten Diode abfällt, temporär reduziert, was die erste, zweite, dritte und/oder vierte Diode entlastet. Weiterhin werden umgekehrt mittels der Dioden die durch die Gleichtaktdrosseln fließenden Ströme in Ihrer Zeitdauer und Höhe reduziert, so dass die Gleichtaktdrosseln kleiner als beim Stand der Technik gebaut werden können.

Ausführungsbeispiele der Erfindung sind in den Figuren dargestellt und werden im Folgenden näher erläutert. Dabei zeigen:
- FIG 1: eine Leistungshalbleitereinrichtung,
- FIG 2: eine erfindungsgemäße Leistungshalbleiterschaltung,
- FIG 3: eine weitere Ausbildung einer erfindungsgemäßen Leistungshalbleiterschaltung,
- FIG 4: eine weitere Ausbildung einer erfindungsgemäßen Leistungshalbleiterschaltung und
- FIG 5: eine weitere Ausbildung einer erfindungsgemäßen Leistungshalbleiterschaltung.

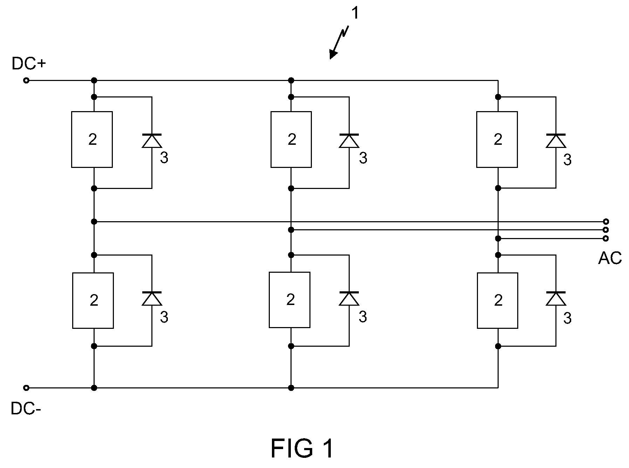

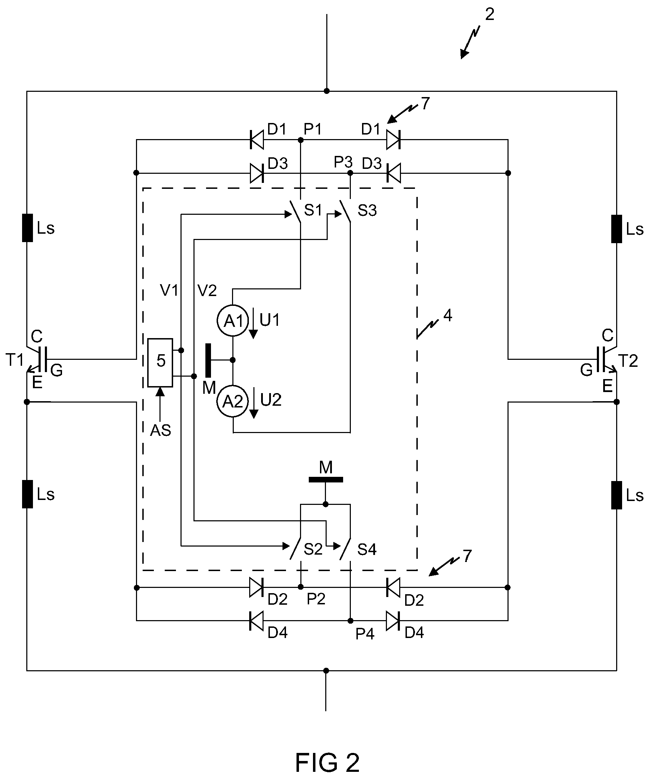

In FIG 1 ist eine Leistungshalbleitereinrichtung 1 dargestellt, die beispielhaft in Form einer sogenannten 3-phasigen Brückenschaltung ausgebildet ist. Die Leistungshalbleitereinrichtung 1 weist im Rahmen des Ausführungsbeispiels sechs erfindungsgemäße Leistungshalbleiterschaltungen 2 auf. In FIG 2 ist eine erfindungsgemäße Leistungshalbleiterschaltung 2 im Detail dargestellt. Den Leistungshalbleiterschaltungen 2 sind beim Ausführungsbeispiel jeweilig eine Freilaufdiode 3 elektrisch antiparallel geschaltet, wobei zu jeder Leistungshalbleiterschaltung 2 auch mehrere Freilaufdioden elektrisch antiparallel geschaltet sein können. Im Rahmen des dargestellten Ausführungsbeispiels erzeugt die Leistungshalbleitereinrichtung 1 aus einer linksseitig zwischen den Gleichspannungsanschlüssen DC+ und DC- eingespeisten Gleichspannung am Wechselspannungsanschluss AC eine 3-phasige Wechselspannung.

Die erfindungsgemäße Leistungshalbleiterschaltung 2 weist mindestens zwei elektrisch parallel geschaltete Leistungshalbleiterschalter T1 und T2 auf, die jeweilig einen ersten Laststromanschluss C, einen zweiten Laststromanschluss E und einen Steueranschluss G aufweisen, wobei die ersten Laststromanschlüsse C der Leistungshalbleiterschalter T1 und T2 elektrisch leitend miteinander verbunden sind und die zweiten Laststromanschlüsse E der Leistungshalbleiterschalter T1 und T2 elektrisch leitend miteinander verbunden sind. Es sei angemerkt, dass die erfindungsgemäße Leistungshalbleiterschaltung selbstverständlich noch mehr elektrisch parallel geschaltete Leistungshalbleiterschalter als die zwei beim Ausführungsbeispiel elektrisch parallel geschalteten Leistungshalbleiterschalter T1 und T2 aufweisen kann. Im Rahmen des Ausführungsbeispiels liegt der erste Laststromanschluss C in Form des Kollektors des jeweiligen Leistungshalbleiterschalters und der zweite Laststromanschluss E in Form des Emitters des jeweiligen Leistungshalbleiterschalters und der Steueranschluss G in Form des Gate des jeweiligen Leistungshalbleiterschalters vor. Die elektrisch parallel geschalteten Leistungshalbleiterschalter liegen vorzugsweise in Form von Transistoren, wie z.B. IGBTs (Insulated Gate Bipolar Transistor) oder MOSFETs (Metal Oxide Semiconductor Field Effect Transistor), wobei im Rahmen des Ausführungsbeispiels die Leistungshalbleiterschalter T1 und T2 in Form von IGBTs vorliegen. Die elektrischen Zuleitungen zu den Leistungshalbleiterschalter T1 und T2 weisen parasitäre Induktivitäten Ls auf.

Aufgrund von Bauteiltoleranzen und unterschiedlicher parasitärer Induktivitäten der Zuleitungen zu den elektrisch parallel geschalteten Leistungshalbleiterschaltern kommt es häufig zu unterschiedlichen Ein- und Ausschaltzeitpunkten der elektrisch parallel geschalteten Leistungshalbleiterschalter. Die unterschiedlichen Ein- und Ausschaltzeitpunkte führen zu elektrischen Potentialverschiebungen an den zweiten Laststromanschlüssen der elektrisch parallel geschalteten Leistungshalbleiterschalter, so dass, wenn keine Maßnahmen dagegen ergriffen werden, die elektrisch parallel geschalteten Leistungshalbleiterschalter sich gegenseitig in Ihrem Schaltverhalten beeinflussen, was zu einer ungleichmäßigen Stromaufteilung zwischen den elektrisch parallel geschalteten Leistungshalbleiterschaltern führt. Beim Einschalten des Leistungshalbleiterschalter T2 nimmt das elektrische Potential des Emitters E des Leistungshalbleiterschalters T2, das elektrische Potential des Kollektors K des Leistungshalbleiterschalter T2 an, was, wenn z.B. Leistungshalbleiterschalter T2 gegenüber Leistungshalbleiterschalters T1 verzögert eingeschaltet wird, zu einer Potentialverschiebung des elektrischen Potentials des Emitters E des Leistungshalbleiterschalters T1 führt. Dies kann z.B. dazu führen, dass die zwischen dem Gate G und dem Emitter E des Leistungshalbleiterschalters T1 anliegende Spannung nicht mehr hoch genug ist um den Leistungshalbleiterschalters T1 im eingeschalteten Zustand zu belassen, so dass der Leistungshalbleiterschalters T1 sich im Extremfall ausschaltet oder aber in einen Zwischenzustand übergeht, bei dem der Durchlasswiderstand des Leistungshalbleiterschalters T1 erhöht ist.

Weiterhin weist die Leistungshalbleiterschaltung 2 eine Ansteuerbeschaltung 7 auf, wobei die Ansteuerbeschaltung 7 einen ersten, zweiten, dritten und einen vierten elektrischen Anschlusspunkt P1, P2, P3 und P4 aufweist, wobei der erste und dritte Anschlusspunkt P1 und P3 elektrisch mit den Steueranschlüssen G der Leistungshalbleiterschalter T1 und T2 verbunden ist und der zweite und vierte Anschlusspunkt P2 und P4 elektrisch mit den zweiten Laststromanschlüssen E der Leistungshalbleiterschalter T1 und T2 verbunden ist, wobei elektrisch zwischen dem ersten Anschlusspunkt P1 und den Steueranschlüssen G der Leistungshalbleiterschalter T1 und T2 jeweilig eine erste Diode D1, deren Anode dem ersten Anschlusspunkt P1 elektrisch zugewandt ist, geschaltet ist, wobei elektrisch zwischen dem zweiten Anschlusspunkt P2 und den zweiten Laststromanschlüssen E der Leistungshalbleiterschalter T1 und T2 jeweilig eine zweite Diode D2, deren Kathode dem zweiten Anschlusspunkt P2 elektrisch zugewandt ist, geschaltet ist, wobei elektrisch zwischen dem dritten Anschlusspunkt P3 und den Steueranschlüssen G der Leistungshalbleiterschalter jeweilig eine dritte Diode D3, deren Kathode dem dritten Anschlusspunkt P3 elektrisch zugewandt ist, geschaltet ist, wobei elektrisch zwischen dem vierten Anschlusspunkt P4 und den zweiten Laststromanschlüssen E der Leistungshalbleiterschalter T1 und T2 jeweilig eine vierte Diode D4, deren Anode dem vierten Anschlusspunkt P4 elektrisch zugewandt ist, geschaltet ist. Im Rahmen des Ausführungsbeispiels ist der erste Anschlusspunkt P1 elektrisch leitend mit der Anode der jeweiligen ersten Diode D1, der zweite Anschlusspunkt P2 elektrisch leitend mit der Kathode der jeweiligen zweiten Diode D2, der dritte Anschlusspunkt P3 elektrisch leitend mit der Kathode der jeweiligen dritten Diode D3 und der vierte Anschlusspunkt P4 elektrisch leitend mit der Anode der jeweiligen vierten Diode D4 verbunden.

Durch die zweiten Dioden D2 und die vierten Dioden D4 werden aufgrund der elektrischen Potentialverschiebungen an den zweiten Laststromanschlüssen E der elektrisch parallel geschalteten Leistungshalbleiterschalter T1 und T2 zwischen den zweiten Laststromanschlüssen E der Leistungshalbleiterschalter T1 und T2 fließende Ausgleichströme verhindert. Die Potentialverschiebungen an den zweiten Laststromanschlüssen E der elektrisch parallel geschalteten Leistungshalbleiterschalter T1 und T2 führen zu entsprechenden elektrischen Spannungsabfällen an den zweiten und vierten Dioden D2 und D4.

Durch die ersten Dioden D1 und die dritten Dioden D3 werden aufgrund elektrischer Potentialverschiebungen an den Steueranschlüssen G der elektrisch parallel geschalteten Leistungshalbleiterschalter T1 und T2 zwischen den Steueranschlüssen G der Leistungshalbleiterschalter T1 und T2 fließende Ausgleichströme verhindert. Die Potentialverschiebungen an den Steueranschlüssen G der elektrisch parallel geschalteten Leistungshalbleiterschalter T1 und T2 führen zu entsprechenden elektrischen Spannungsabfällen an den ersten und dritten Dioden D1 und D3.

Weiterhin weist die Leistungshalbleiterschaltung 2 eine Ansteuerschaltung 4 auf, die beim Ausführungsbeispiel mittels einer ersten Spannungsquelle A1, bezogen auf eine elektrische Masse M der Leistungshalbleiterschaltung 2, eine positive elektrische Spannung U1 (z.B. 15V erzeugt und beim Ausführungsbeispiel mittels einer zweiten Spannungsquelle A2, bezogen auf die elektrische Masse M der Leistungshalbleiterschaltung 2, eine negative elektrische Spannung U2 (z.B. -8V) erzeugt. Die erste Spannungsquelle A1 erzeugt dabei die positive elektrische Spannung U1 und die zweite Spannungsquelle A1 erzeugt dabei die negative elektrische Spannung U2.

Die Ansteuerschaltung 4 ist derart ausgebildet, dass die Ansteuerschaltung 4 zum Einschalten der Leistungshalbleiterschalter T1 und T2 die positive elektrische Spannung U1 auf den ersten Anschlusspunkt P1 der Ansteuerbeschaltung 7 aufschaltet und den zweiten Anschlusspunkt P2 der Ansteuerbeschaltung 7 elektrisch mit der Masse M der Leistungshalbleiterschaltung 2 verbindet und die negative elektrische Spannung U2 vom dritten Anschlusspunkt P3 wegschaltet und den vierten Anschlusspunkt P4 der Ansteuerbeschaltung 7 elektrisch von der elektrischen Masse M der Leistungshalbleiterschaltung 2 trennt. Das Aufschalten der positiven elektrischen Spannung U1, das elektrische Trennen und Verbinden der elektrischen Masse M und das Wegschalten der negativen elektrische Spannung U2 laufen dabei vorzugsweise gleichzeitig ab.

Die Ansteuerschaltung 4 ist weiterhin derart ausgebildet ist, dass die Ansteuerschaltung 4 zum Ausschalten der Leistungshalbleiterschalter T1 und T2 die negative elektrische Spannung U2 auf den dritten Anschlusspunkt P3 der Ansteuerbeschaltung 7 aufschaltet und den vierten Anschlusspunkt P4 der Ansteuerbeschaltung 7 elektrisch mit der elektrischen Masse M der Leistungshalbleiterschaltung 2 verbindet und die positive elektrische Spannung U1 vom ersten Anschlusspunkt P1 wegschaltet und den zweiten Anschlusspunkt P2 der Ansteuerbeschaltung 7 elektrisch von der elektrischen Masse M der Leistungshalbleiterschaltung 2 trennt. Das Aufschalten der negativen Spannung U2, das elektrische Trennen und Verbinden der elektrischen Masse M und das Wegschalten der positiven elektrischen Spannung U1 laufen dabei vorzugsweise gleichzeitig ab.

Zum Durchführen der oben genannten Schalthandlungen weist die Ansteuerschaltung 4 im Rahmen des Ausführungsbeispiels einen elektrisch zwischen den ersten Anschlusspunkt P1 und der ersten Spannungsquelle A1 geschalten ersten Halbleiterschalter S1, einen elektrisch zwischen den zweiten Anschlusspunkt P2 und der elektrischen Masse M der Leistungshalbleiterschaltung 2 geschalten zweiten Halbleiterschalter S2, einen elektrisch zwischen den dritten Anschlusspunkt P3 und der zweiten Spannungsquelle A2 geschalten dritten Halbleiterschalter S3, einen elektrisch zwischen den vierten Anschlusspunkt P4 und der elektrischen Masse M der Leistungshalbleiterschaltung 2 geschalten vierten Halbleiterschalter S4 und eine Logikeinheit 5 auf. Die Logikeinheit 5 erzeugt in Abhängigkeit eines Ein-/Ausschaltsignals AS, das festlegt ob die elektrisch parallel geschalteten Leistungshalbleiterschalter T1 und T2 ein- oder ausgeschaltet werden sollen, ein erstes Schaltsignal V1 zur Ansteuerung des ersten und zweiten Halbleiterschalters S1 und S2 und ein zweites Schaltsignal V2 zur Ansteuerung des zweiten und vierten Halbleiterschalters S3 und S4. Die Halbleiterschalter S1, S2, S3 und S4 sind vorzugsweise als MOSFET ausgebildet.

Die positive elektrische Spannung U1 wird auf den ersten Anschlusspunkt P1 aufschaltet, indem der erste Halbleiterschalter S1 mittels des ersten Schaltsignals V1 eingeschaltet und somit geschlossen wird. Der zweite Anschlusspunkt P2 wird elektrisch mit der Masse M der Leistungshalbleiterschaltung 2 verbunden, indem der zweite Halbleiterschalter S2 mittels des ersten Schaltsignals V1 eingeschaltet und somit geschlossen wird. Die negative elektrische Spannung U2 wird vom dritten Anschlusspunkt P3 wegschaltet, indem der dritte Halbleiterschalter S3 mittels des zweiten Schaltsignals V2 ausgeschaltet und somit geöffnet wird. Der vierte Anschlusspunkt P4 wird elektrisch von der elektrischen Masse M der Leistungshalbleiterschaltung 2 getrennt, indem der vierte Halbleiterschalter S4 mittels des zweiten Schaltsignals V2 ausgeschaltet und somit geöffnet wird.

Die negative elektrische Spannung U2 wird auf den dritten Anschlusspunkt P3 aufschaltet, indem der dritte Halbleiterschalter S3 mittels des zweiten Schaltsignals V2 eingeschaltet und somit geschlossen wird. Der vierte Anschlusspunkt P4 wird elektrisch mit der elektrischen Masse M der Leistungshalbleiterschaltung 2 verbunden, indem der vierte Halbleiterschalter S4 mittels des zweiten Schaltsignals V2 eingeschaltet und somit geschlossen wird. Die positive elektrische Spannung U1 wird vom ersten Anschlusspunkt P1 wegschaltet, indem der erste Halbleiterschalter S1 mittels des ersten Schaltsignals V1 ausgeschaltet und somit geöffnet wird. Der zweite Anschlusspunkt P2 wird elektrisch von der elektrischen Masse M der Leistungshalbleiterschaltung 2 getrennt, indem der zweite Halbleiterschalter S2 mittels des ersten Schaltsignals V1 ausgeschaltet und somit geöffnet wird.

Wenn das Ein-/Ausschaltsignal AS festlegt, dass die elektrisch parallel geschalteten Leistungshalbleiterschalter T1 und T2 eingeschaltet werden sollen, werden von der Logikeinheit 5 der erste und zweite Halbleiterschalter S1 und S2 geschlossen und der dritte und vierte Halbleiterschalter S3 und S4 geöffnet. Wenn das Ein-/Ausschaltsignal AS festlegt, dass die elektrisch parallel geschalteten Leistungshalbleiterschalter T1 und T2 ausgeschaltet werden sollen, werden von der Logikeinheit 5 der dritte und vierte Halbleiterschalter S3 und S4 geschlossen und der erste und zweite Halbleiterschalter S1 und S2 geöffnet. Das Ein-/Ausschaltsignal AS wird von einer übergeordneten Steuereinrichtung erzeugt.

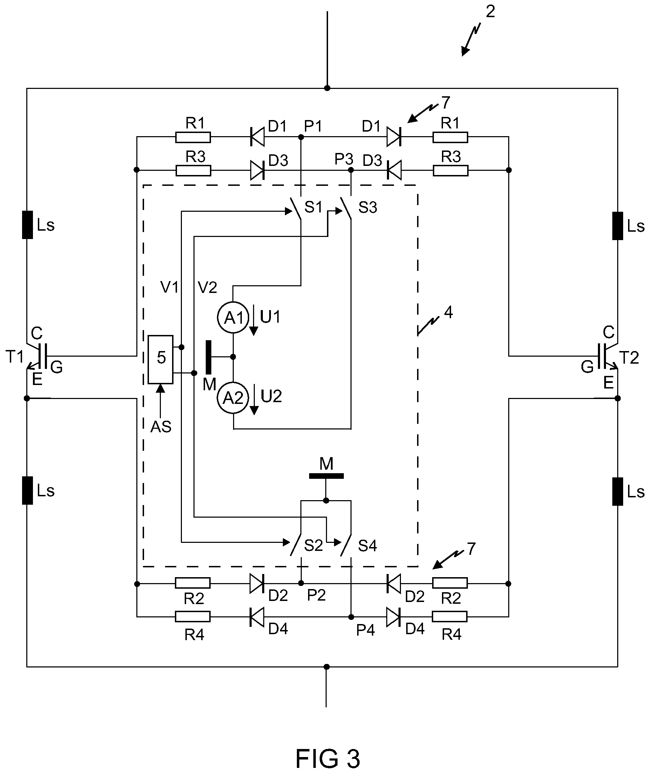

Wie in FIG 3 dargestellt kann zur jeweiligen ersten Diode D1 ein erster elektrischer Widerstand R1 elektrisch in Reihe geschaltet sein. Durch entsprechende Wahl des Widerstandswerts des ersten elektrischen Widerstands R1 kann die Einschaltgeschwindigkeit der Leistungshalbleiterschalter T1 und T2 an die konkreten Erfordernisse der jeweiligen Anwendung der Leistungshalbleiterschaltung angepasst werden. Weiterhin kann zur jeweiligen dritten Diode D3 ein dritter elektrischer Widerstand R3 elektrisch in Reihe geschaltet sein. Durch entsprechende Wahl des Widerstandswerts des dritten elektrischen Widerstands R3 kann die Ausschaltgeschwindigkeit der Leistungshalbleiterschalter T1 und T2 an die konkreten Erfordernisse der jeweiligen Anwendung der Leistungshalbleiterschaltung angepasst werden.

Weiterhin kann, wie in FIG 3 dargestellt, zur jeweiligen zweiten Diode D2 ein zweiter elektrischer Widerstand R2 elektrisch in Reihe geschaltet sein und somit z.B. zum Schutz der zweiten Dioden D2, die durch die zweiten Dioden D2 fließenden Ströme begrenzt werden. Weiterhin kann zur jeweiligen vierten Diode D4 ein vierter elektrischer Widerstand R4 elektrisch in Reihe geschaltet sein und somit z.B. zum Schutz der vierten Dioden D4, die durch die vierten Dioden D4 fließenden Ströme begrenzt werden.

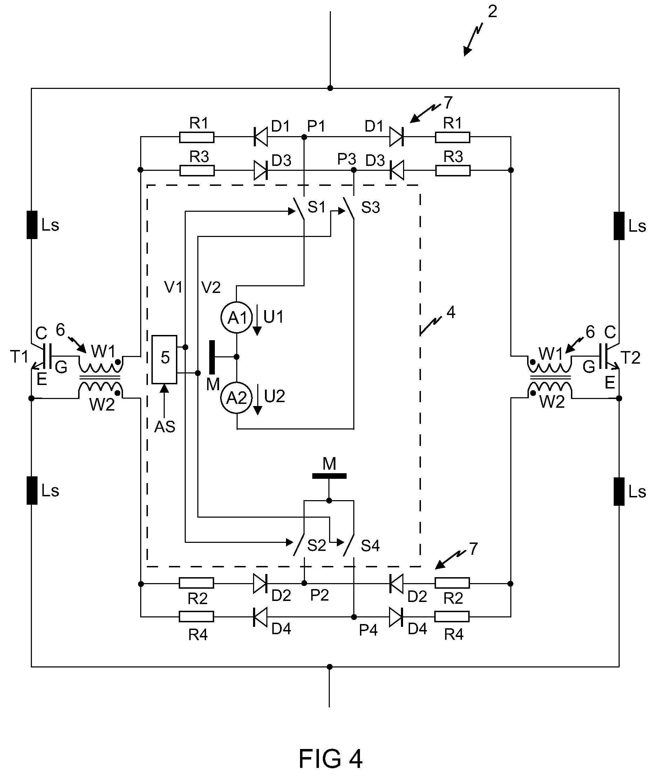

Ferner kann, wie in FIG 4 dargestellt, elektrisch zwischen der ersten, zweiten, dritten und vierten Diode D1, D2, D3 und D4 und dem jeweiligen Leistungshalbleiterschalter T1 bzw. T2 eine Gleichtaktdrossel 6 geschaltet sein, wobei die Gleichtaktdrossel 6 eine erste Wicklung W1 und eine mit der ersten Wicklung W1 magnetisch gekoppelte zweite Wicklung W2 aufweist, wobei die erste Wicklung W1 elektrisch zwischen den Steueranschluss G des jeweiligen Leistungshalbleiterschalters T1 bzw. T2 und der Kathode der ersten Diode D1 und der Anode der dritten Diode D3 geschaltet ist, und die zweite Wicklung W2 elektrisch zwischen dem zweiten Laststromanschluss E des jeweiligen Leistungshalbleiterschalters T1 bzw. T2 und der Anode der zweiten Diode D2 und der Kathode der vierten Diode D4 geschaltet ist. Die Gleichtaktdrosseln 6 nehmen temporär die im Schaltmoment beim Ein- und Ausschalten der Leistungshalbleiterschalter T1 und T2 auftretende elektrische Potentialdifferenz der zweiten Laststromanschlüsse E der Leistungshalbleiterschalter T1 und T2 auf, so dass temporär an der ersten und zweiten Wicklung W1 und W2 eine entsprechende elektrische Spannung abfällt und so die elektrische Spannung, welche über der ersten, zweiten, dritten und/oder vierten Diode abfällt, temporär reduziert wird, was die erste, zweite, dritte und/oder vierte Diode entlastet. Weiterhin werden umgekehrt mittels der Dioden die durch die Gleichtaktdrosseln fließenden Ströme in Ihrer Zeitdauer und Höhe reduziert, so dass die Gleichtaktdrosseln kleiner als beim Stand der Technik gebaut werden können.

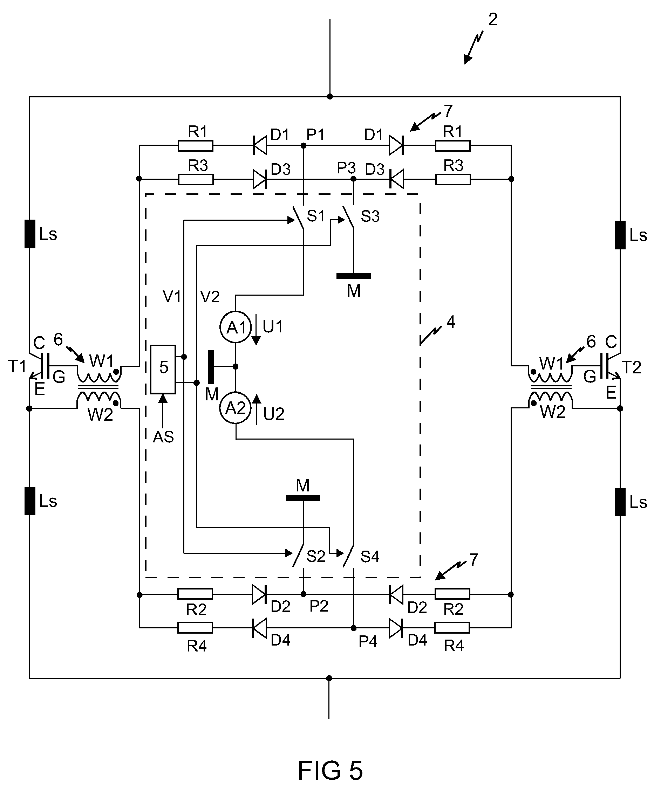

In FIG 5 ist eine weitere Ausbildung einer erfindungsgemäßen Leistungshalbleiterschaltung 2 dargestellt, wobei diese Ausbildung der Erfindung mit den in den Figuren 2 bis 4 dargestellten Ausführungsbeispielen bis auf die Ausbildung der Ansteuerschaltung 4 übereinstimmt. Die Ausbildung der Erfindung gemäß FIG 5 weist eine gegenüber den Ausbildungen der Erfindung gemäß FIG 2 bis FIG 4 modifizierte Ansteuerschaltung 4 auf. Die Ansteuerschaltung 4 gemäß FIG 5 erzeugt bezogen auf die elektrische Masse M der Leistungshalbleiterschaltung 2, mittels einer ersten Spannungsquelle A1, eine erste positive Spannung U1 (z.B. 15V) und mittels einer zweiten Spannungsquelle A2, eine zweite positive elektrische Spannung U2 (z.B. 8V), wobei die Ansteuerschaltung 4 derart ausgebildet ist, dass die Ansteuerschaltung 4 zum Einschalten der Leistungshalbleiterschalter T1 und T2 die erste positive elektrische Spannung U1 auf den ersten Anschlusspunkt P1 der Ansteuerbeschaltung 7 aufschaltet und den zweiten Anschlusspunkt P2 der Ansteuerbeschaltung 7 elektrisch mit der Masse M der Leistungshalbleiterschaltung 2 verbindet und die zweite positive elektrische Spannung U2 vom vierten Anschlusspunkt P4 wegschaltet und den dritten Anschlusspunkt P3 der Ansteuerbeschaltung 7 elektrisch von der elektrischen Masse M der Leistungshalbleiterschaltung 2 trennt, wobei die Ansteuerschaltung 4 derart ausgebildet ist, dass die Ansteuerschaltung 4 zum Ausschalten der Leistungshalbleiterschalter 2 die zweite positive elektrische Spannung U2 auf den vierten Anschlusspunkt P4 der Ansteuerbeschaltung 7 aufschaltet und den dritten Anschlusspunkt P3 der Ansteuerbeschaltung 7 elektrisch mit der elektrischen Masse M der Leistungshalbleiterschaltung 2 verbindet und die erste positive elektrische Spannung U1 vom ersten Anschlusspunkt P1 wegschaltet und den zweiten Anschlusspunkt P2 der Ansteuerbeschaltung 7 elektrisch von der elektrischen Masse M der Leistungshalbleiterschaltung 2 trennt. Das Wegschalten und Aufschalten der ersten und zweiten positiven elektrische Spannung U1 und U2 und das Verbinden und Trennen der Masse M wird in analoger Form wie bei den in Figuren 2 bis 4 dargestellten Ausführungsbeispielen mittels des ersten, zweiten, dritten und vierten Halbleiterschalters S1, S2, S3 und S4 und der Logikeinheit 5 durchgeführt.

Verallgemeinert ausgedrückt ist die Ansteuerschaltung 4, derart ausgebildet ist, dass die Ansteuerschaltung 4 zum Einschalten der Leistungshalbleiterschalter T1 und T2 zwischen dem ersten und zweiten Anschlusspunkt P1 und P2 eine erste elektrische Potentialdifferenz erzeugt, wobei dabei der erste Anschlusspunkt P1 gegenüber dem zweiten Anschlusspunkt P2 ein positives elektrisches Potential aufweist, und zum Ausschalten der Leistungshalbleiterschalter T1 und T2 zwischen dem dritten und vierten Anschlusspunkt P1 und P2 eine zweite elektrische Potentialdifferenz erzeugt, wobei dabei der dritte Anschlusspunkt P3 gegenüber dem vierten Anschlusspunkt P4 ein negatives elektrisches Potential aufweist.

Es sei weiterhin angemerkt, dass unter dem Ausdruck "magnetisch gekoppelte" im Sinne der Erfindung eine mittels eines magnetisch leitfähigen Kerns, wie z.B. einem Eisenkern oder Ferritkern, bestehende magnetische Kopplung zwischen Wicklungen verstanden wird. Die magnetisch gekoppelten Wicklungen sind hierzu um den magnetisch leitfähigen Kern gewickelt.

## Patentansprüche

1. Leistungshalbleiterschaltung aufweisend,
• mindestens zwei elektrisch parallel geschaltete Leistungshalbleiterschalter (T1,T2), die jeweilig einen ersten und einen zweiten Laststromanschluss (C,E) und einen Steueranschluss (G) aufweisen, wobei die ersten Laststromanschlüsse (C) der Leistungshalbleiterschalter (T1,T2) elektrisch leitend miteinander verbunden sind und die zweiten Laststromanschlüsse (E) der Leistungshalbleiterschalter (T1,T2) elektrisch leitend miteinander verbunden sind,
• eine Ansteuerbeschaltung (7), wobei die Ansteuerbeschaltung (7) einen ersten, zweiten, dritten und einen vierten elektrischen Anschlusspunkt (P1,P2,P3,P4) aufweist, wobei der erste und dritte Anschlusspunkt (P1,P3) elektrisch mit den Steueranschlüssen (G) der Leistungshalbleiterschalter (T1,T2) verbunden ist und der zweite und vierte Anschlusspunkt (P2,P4) elektrisch mit den zweiten Laststromanschlüssen (E) der Leistungshalbleiterschalter (T1,T2) verbunden ist, wobei elektrisch zwischen dem ersten Anschlusspunkt (P1) und den Steueranschlüssen (G) der Leistungshalbleiterschalter (T1,T2) jeweilig eine erste Diode (D1), deren Anode dem ersten Anschlusspunkt (D1) elektrisch zugewandt ist, geschaltet ist, wobei elektrisch zwischen dem zweiten Anschlusspunkt (P2) und den zweiten Laststromanschlüssen (E) der Leistungshalbleiterschalter (T1,T2) jeweilig eine zweite Diode (D2), deren Kathode dem zweiten Anschlusspunkt (P2) elektrisch zugewandt ist, geschaltet ist, wobei elektrisch zwischen dem dritten Anschlusspunkt (P3) und den Steueranschlüssen (G) der Leistungshalbleiterschalter (T1,T2) jeweilig eine dritte Diode (D3), deren Kathode dem dritten Anschlusspunkt (P3) elektrisch zugewandt ist, geschaltet ist, wobei elektrisch zwischen dem vierten Anschlusspunkt (P4) und den zweiten Laststromanschlüssen (E) der Leistungshalbleiterschalter (T1,T2) jeweilig eine vierte Diode (D4), deren Anode dem vierten Anschlusspunkt (P4) elektrisch zugewandt ist, geschaltet ist, und
• eine Ansteuerschaltung (4), wobei die Ansteuerschaltung (4), derart ausgebildet ist, dass die Ansteuerschaltung (4) zum Einschalten der Leistungshalbleiterschalter (T1,T2) zwischen dem ersten und zweiten Anschlusspunkt (P1,P2) eine erste elektrische Potentialdifferenz und zum Ausschalten der Leistungshalbleiterschalter (T1,T2) zwischen dem dritten und vierten Anschlusspunkt (P3, P4) eine zweite elektrische Potentialdifferenz erzeugt.

2. Leistungshalbleiterschaltung nach Anspruch 1, **dadurch gekennzeichnet, dass** die Ansteuerschaltung (4) bezogen auf eine elektrische Masse (M) der Leistungshalbleiterschaltung (2) eine positive und eine negative elektrische Spannung (U1,U2) erzeugt, wobei die Ansteuerschaltung (4) derart ausgebildet ist, dass die Ansteuerschaltung (4) zum Einschalten der Leistungshalbleiterschalter (T1,T2) die positive elektrische Spannung (U1) auf den ersten Anschlusspunkt (P1) der Ansteuerbeschaltung (7) aufschaltet und den zweiten Anschlusspunkt (P2) der Ansteuerbeschaltung (7) elektrisch mit der Masse (M) der Leistungshalbleiterschaltung (2) verbindet und die negative elektrische Spannung (U2) vom dritten Anschlusspunkt (P3) wegschaltet und den vierten Anschlusspunkt (P4) der Ansteuerbeschaltung (7) elektrisch von der elektrischen Masse (M) der Leistungshalbleiterschaltung (2) trennt,
wobei die Ansteuerschaltung (4) derart ausgebildet ist, dass die Ansteuerschaltung (4) zum Ausschalten der Leistungshalbleiterschalter (2) die negative elektrische Spannung (U2) auf den dritten Anschlusspunkt (P3) der Ansteuerbeschaltung (7) aufschaltet und den vierten Anschlusspunkt (P4) der Ansteuerbeschaltung (7) elektrisch mit der elektrischen Masse (M) der Leistungshalbleiterschaltung (2) verbindet und die positive elektrische Spannung (U1) vom ersten Anschlusspunkt (P1) wegschaltet und den zweiten Anschlusspunkt (P2) der Ansteuerbeschaltung (7) elektrisch von der elektrischen Masse (M) der Leistungshalbleiterschaltung (2) trennt.

3. Leistungshalbleiterschaltung nach Anspruch 1, **dadurch gekennzeichnet, dass** die Ansteuerschaltung (4) bezogen auf eine elektrische Masse (M) der Leistungshalbleiterschaltung (2) eine erste positive und eine zweite positive elektrische Spannung (U1,U2) erzeugt, wobei die Ansteuerschaltung (4) derart ausgebildet ist, dass die Ansteuerschaltung (4) zum Einschalten der Leistungshalbleiterschalter (T1,T2) die erste positive elektrische Spannung (U1) auf den ersten Anschlusspunkt (P1) der Ansteuerbeschaltung (7) aufschaltet und den zweiten Anschlusspunkt (P2) der Ansteuerbeschaltung (7) elektrisch mit der Masse (M) der Leistungshalbleiterschaltung (2) verbindet und die zweite positive elektrische Spannung (U2) vom vierten Anschlusspunkt (P4) wegschaltet und den dritten Anschlusspunkt (P3) der Ansteuerbeschaltung (7) elektrisch von der elektrischen Masse (M) der Leistungshalbleiterschaltung (2) trennt, wobei die Ansteuerschaltung (4) derart ausgebildet ist, dass die Ansteuerschaltung (4) zum Ausschalten der Leistungshalbleiterschalter (2) die zweite positive elektrische Spannung (U2) auf den vierten Anschlusspunkt (P4) der Ansteuerbeschaltung (7) aufschaltet und den dritten Anschlusspunkt (P3) der Ansteuerbeschaltung (7) elektrisch mit der elektrischen Masse (M) der Leistungshalbleiterschaltung (2) verbindet und die erste positive elektrische Spannung (U1) vom ersten Anschlusspunkt (P1) wegschaltet und den zweiten Anschlusspunkt (P2) der Ansteuerbeschaltung (7) elektrisch von der elektrischen Masse (M) der Leistungshalbleiterschaltung (2) trennt.

4. Leistungshalbleiterschaltung nach einem der vorhergehenden Ansprüche, **dadurch gekennzeichnet, dass** zur jeweiligen ersten Diode (D1) ein erster elektrischer Widerstand (R1) elektrisch in Reihe geschaltet ist.

5. Leistungshalbleiterschaltung nach einem der vorhergehenden Ansprüche, **dadurch gekennzeichnet, dass** zur jeweiligen dritten Diode (D3) ein dritter elektrischer Widerstand (R3) elektrisch in Reihe geschaltet ist.

6. Leistungshalbleiterschaltung nach einem der vorhergehenden Ansprüche, **dadurch gekennzeichnet, dass** zur jeweiligen zweiten Diode (D2) ein zweiter elektrischer Widerstand (R2) elektrisch in Reihe geschaltet ist.

7. Leistungshalbleiterschaltung nach einem der vorhergehenden Ansprüche, **dadurch gekennzeichnet, dass** zur jeweiligen vierten Diode (D4) ein vierter elektrischer Widerstand (R4) elektrisch in Reihe geschaltet ist.

8. Leistungshalbleiterschaltung nach einem der vorhergehenden Ansprüche, **dadurch gekennzeichnet, dass** elektrisch zwischen der ersten, zweiten, dritten und vierten Diode (D1,D2,D3,D4) und dem jeweiligen Leistungshalbleiterschalter (T1,T2) eine Gleichtaktdrossel (6) geschaltet ist, wobei die Gleichtaktdrossel (6) eine erste Wicklung (W1) und eine mit der ersten Wicklung (W1) magnetisch gekoppelte zweite Wicklung (W2) aufweist, wobei die erste Wicklung (W1) elektrisch zwischen den Steueranschluss (G) des jeweiligen Leistungshalbleiterschalters (T1,T2) und der Kathode der ersten Diode (D1) und der Anode der dritten Diode (D3) geschaltet ist, und die zweite Wicklung (W2) elektrisch zwischen dem zweiten Laststromanschluss (E) des jeweiligen Leistungshalbleiterschalters (T1,T2) und der Anode der zweiten Diode (D2) und der Kathode der vierten Diode (D4) geschaltet ist.

## Claims

1. Power semiconductor circuit comprising
• at least two power semiconductor switches (T1, T2), which are connected electrically in parallel and each have a first and a second load current connection (C, E) and a control connection (G), wherein the first load current connections (C) of the power semiconductor switches (T1, T2) are electrically conductively connected to one another and the second load current connections (E) of the power semiconductor switches (T1, T2) are electrically conductively connected to one another,
• a drive circuit arrangement (7), wherein the drive circuit arrangement (7) has a first, second, third and fourth electrical connection point (P1, P2, P3, P4), wherein the first and third connection points (P1, P3) are electrically connected to the control connections (G) of the power semiconductor switches (T1, T2), and the second and fourth connection points (P2, P4) are electrically connected to the second load current connections (E) of the power semiconductor switches (T1, T2), wherein in each case a first diode (D1), whose anode faces electrically the first connection point (D1), is connected electrically between the first connection point (P1) and the control connections (G) of the power semiconductor switches (T1, T2), wherein in each case a second diode (D2), whose cathode faces electrically the second connection point (P2), is connected electrically between the second connection point (P2) and the second load current connections (E) of the power semiconductor switches (T1, T2), wherein in each case a third diode (D3), whose cathode faces electrically the third connection point (P3), is connected electrically between the third connection point (P3) and the control connections (G) of the power semiconductor switches (T1, T2), wherein in each case a fourth diode (D4), whose anode faces electrically the fourth connection point (P4), is connected electrically between the fourth connection point (P4) and the second load current connections (E) of the power semiconductor switches (T1, T2), and
• a drive circuit (4), wherein the drive circuit (4) is designed in such a way that the drive circuit (4) generates a first electrical potential difference for switching on the power semiconductor switches (T1, T2) between the first and second connection points (P1, P2) and a second electrical potential difference for switching off the power semiconductor switches (T1, T2) between the third and fourth connection points (P3, P4).

2. Power semiconductor circuit according to Claim 1, **characterized in that** the drive circuit (4), in relation to an electrical ground (M) of the power semiconductor circuit (2), generates a positive and a negative electric voltage (U1, U2), wherein the drive circuit (4) is designed in such a way that the drive circuit (4), in order to switch on the power semiconductor switches (T1, T2), switches the positive electric voltage (U1) onto the first connection point (P1) of the drive circuit arrangement (7) and connects the second connection point (P2) of the drive circuit arrangement (7) electrically to the ground (M) of the power semiconductor circuit (2) and switches the negative electric voltage (U2) away from the third connection point (P3) and isolates the fourth connection point (P4) of the drive circuit arrangement (7) electrically from the electrical ground (M) of the power semiconductor circuit (2), wherein the drive circuit (4) is designed in such a way that the drive circuit (4), in order to switch off the power semiconductor switches (2), switches the negative electric voltage (U2) onto the third connection point (P3) of the drive circuit arrangement (7) and connects the fourth connection point (P4) of the drive circuit arrangement (7) electrically to the electrical ground (M) of the power semiconductor circuit (2) and switches the positive electric voltage (U1) away from the first connection point (P1) and isolates the second connection point (P2) of the drive circuit arrangement (7) electrically from the electrical ground (M) of the power semiconductor circuit (2).

3. Power semiconductor circuit according to Claim 1, **characterized in that** the drive circuit (4), in relation to an electrical ground (M) of the power semiconductor circuit (2), generates a first positive and a second positive electric voltage (U1, U2), wherein the drive circuit (4) is designed in such a way that the drive circuit (4), in order to switch on the power semiconductor switches (T1, T2), switches the first positive electric voltage (U1) onto the first connection point (P1) of the drive circuit arrangement (7) and connects the second connection point (P2) of the drive circuit arrangement (7) electrically to the ground (M) of the power semiconductor circuit (2) and switches the second positive electric voltage (U2) away from the fourth connection point (P4) and isolates the third connection point (P3) of the drive circuit arrangement (7) electrically from the electrical ground (M) of the power semiconductor circuit (2), wherein the drive circuit (4) is designed in such a way that the drive circuit (4), in order to switch off the power semiconductor switches (2), switches the second positive electric voltage (U2) onto the fourth connection point (P4) of the drive circuit arrangement (7) and connects the third connection point (P3) of the drive circuit arrangement (7) electrically to the electrical ground (M) of the power semiconductor circuit (2) and switches the first positive electric voltage (U1) away from the first connection point (P1) and isolates the second connection point (P2) of the drive circuit arrangement (7) electrically from the electrical ground (M) of the power semiconductor circuit (2).

4. Power semiconductor circuit according to one of the preceding claims, **characterized in that** a first electrical resistor (R1) is connected electrically in series with the corresponding first diode (D1).

5. Power semiconductor circuit according to one of the preceding claims, **characterized in that** a third electrical resistor (R3) is connected electrically in series with the corresponding third diode (D3).

6. Power semiconductor circuit according to one of the preceding claims, **characterized in that** a second electrical resistor (R2) is connected electrically in series with the corresponding second diode (D2).

7. Power semiconductor circuit according to one of the preceding claims, **characterized in that** a fourth electrical resistor (R4) is connected electrically in series with the corresponding fourth diode (D4).

8. Power semiconductor circuit according to one of the preceding claims, **characterized in that** a common-mode inductor (6) is connected electrically between the first, second, third and fourth diodes (D1, D2, D3, D4) and the corresponding power semiconductor switch (T1, T2), wherein the common-mode inductor (6) has a first winding (W1) and a second winding (W2), which is magnetically coupled to the first winding (W1), wherein the first winding (W1) is connected electrically between the control connection (G) of the corresponding power semiconductor switch (T1, T2) and the cathode of the first diode (D1) and the anode of the third diode (D3), and the second winding (W2) is connected electrically between the second load current connection (E) of the corresponding power semiconductor switch (T1, T2) and the anode of the second diode (D2) and the cathode of the fourth diode (D4).

## Revendications

1. Circuit semi-conducteur de puissance présentant
• au moins deux commutateurs semi-conducteurs de puissance (T1, T2) raccordés électriquement en parallèle et présentant chacun une première et une deuxième borne de raccordement (C, E) de courant de charge et une borne de commande (G), les premières bornes de raccordement (C) de courant de charge des commutateurs semi-conducteurs de puissance (T1, T2) étant raccordées l'une à l'autre de manière électriquement conductrice et les deuxièmes bornes de raccordement (E) de courant de charge des commutateurs semi-conducteurs de puissance (T1, T2) étant raccordées l'une à l'autre de manière électriquement conductrice,
• un circuit de commande (7) le circuit de commande (7) présentant un premier, un deuxième, un troisième et un quatrième point de raccordement électrique (P1, P2, P3, P4), le premier et le troisième point de raccordement (P1, P3) étant raccordés électriquement aux bornes de commande (G) des commutateurs semi-conducteurs de puissance (T1, T2) et le deuxième et le quatrième point de raccordement (P2, P4) étant raccordés électriquement aux deuxièmes bornes de raccordement (E) de courant de charge des commutateurs semi-conducteurs de puissance (T1, T2),
une première diode (D1) dont l'anode est raccordée électriquement au premier point de raccordement (D1) étant raccordée électriquement entre le premier point de raccordement (P1) et les bornes de commande (G) des commutateurs semi-conducteurs de puissance (T1, T2),
une deuxième diode (D2) dont la cathode est raccordée électriquement au deuxième point de raccordement (P2) étant raccordée électriquement entre le deuxième point de raccordement (P2) et les deuxièmes bornes (E) de raccordement de courant de charge des commutateurs semi-conducteurs de puissance (T1, T2),
une troisième diode (D3) dont la cathode est raccordée électriquement au troisième point de raccordement (P3) étant raccordée électriquement entre le troisième point de raccordement (P3) et les bornes de commande (G) des commutateurs semi-conducteurs de puissance (T1, T2),
une quatrième diode (D4) dont l'anode est raccordée électriquement au quatrième point de raccordement (P4) étant raccordée électriquement entre le quatrième point de raccordement (P4) et les deuxièmes bornes (E) de raccordement de courant de charge des commutateurs semi-conducteurs de puissance (T1, T2), et
• un circuit de commande (4), le circuit de commande (4) étant configuré de telle sorte que le circuit de commande (4) forme pour le branchement des commutateurs semi-conducteurs de puissance (T1, T2) une première différence de potentiel électrique entre le premier et le deuxième point de raccordement (P1, P2) et une deuxième différence de potentiel entre le troisième et le quatrième point de raccordement (P3, P4) pour brancher les commutateurs semi-conducteurs de puissance (T1, T2).

2. Circuit semi-conducteur de puissance selon la revendication 1, **caractérisé en ce que** le circuit de commande (4) forme une tension électrique positive et une tension électrique négative (U1, U2) par rapport à la masse électrique (M) du circuit (2) semi-conducteur de puissance,
le circuit de commande (4) étant configuré de telle sorte que pour brancher les commutateurs semi-conducteurs de puissance (T1, T2), le circuit de commande (4) branche la tension électrique positive (U1) sur le premier point de raccordement (P1) du circuit de commande (7), relie électriquement le deuxième point de raccordement (P2) du circuit de commande (7) à la masse (M) du circuit semi-conducteur de puissance (2), débranche la tension électrique négative (U2) du troisième point de raccordement (P3) et sépare électriquement de la masse électrique (M) du circuit semi-conducteur de puissance (2) le quatrième point de raccordement (P4) du circuit de commande (7),
le circuit de commande (4) étant configuré de telle sorte que pour débrancher les commutateurs semi-conducteurs de puissance (2), le circuit de commande (4) branche la tension électrique négative (U2) sur le troisième point de raccordement (P3) du circuit de commande (7), relie électriquement le quatrième point de raccordement (P4) du circuit de commande (7) à la masse électrique (M) du circuit semi-conducteur de puissance (2), débranche la tension électrique positive (U1) du premier point de raccordement (P1) et sépare électriquement le deuxième point de raccordement (P2) du circuit de commande (7) de la masse électrique (M) du circuit semi-conducteur de puissance (2).

3. Circuit semi-conducteur de puissance selon la revendication 1, **caractérisé en ce que** le circuit de commande (4) forme une première tension électrique positive et une deuxième tension électrique positive (U1, U2) par rapport à la masse électrique (M) du circuit semi-conducteur de puissance (2),
le circuit de commande (4) étant configuré de telle sorte que pour brancher les commutateurs semi-conducteurs de puissance (T1, T2), le circuit de commande (4) branche la première tension électrique positive (U1) sur le premier point de raccordement (P1) du circuit de commande (7), relie électriquement le deuxième point de raccordement (P2) du circuit de commande (7) à la masse (M) du circuit semi-conducteur de puissance (2), débranche la deuxième tension électrique positive (U2) du quatrième point de raccordement (P4) et sépare électriquement de la masse électrique (M) du circuit semi-conducteur de puissance (2) le troisième point de raccordement (P3) du circuit de commande (7),
le circuit de commande (4) étant configuré de telle sorte que pour débrancher les commutateurs semi-conducteurs de puissance (2), le circuit de commande (4) branche la deuxième tension électrique positive (U2) sur le quatrième point de raccordement (P4) du circuit de commande (7), relie électriquement le troisième point de raccordement (P3) du circuit de commande (7) à la masse électrique (M) du circuit semi-conducteur de puissance (2), débranche la première tension électrique positive (U1) du premier point de raccordement (P1) et sépare électriquement le deuxième point de raccordement (P2) du circuit de commande (7) de la masse électrique (M) du circuit semi-conducteur de puissance (2).

4. Circuit semi-conducteur de puissance selon l'une des revendications précédentes, **caractérisé en ce qu'**une première résistance électrique (R1) est raccordée en série sur chaque première diode (D1).

5. Circuit semi-conducteur de puissance selon l'une des revendications précédentes, **caractérisé en ce qu'**une troisième résistance électrique (R3) est raccordée électriquement en série sur chaque troisième diode (D3).

6. Circuit semi-conducteur de puissance selon l'une des revendications précédentes, **caractérisé en ce qu'**une deuxième résistance électrique (R2) est raccordée en série sur chaque deuxième diode (D2).

7. Circuit semi-conducteur de puissance selon l'une des revendications précédentes, **caractérisé en ce qu'**une quatrième résistance électrique (R4) est raccordée en série sur chaque quatrième diode (D4).

8. Circuit semi-conducteur de puissance selon l'une des revendications précédentes, **caractérisé en ce qu'**entre la première, la deuxième, la troisième et la quatrième diode (D1, D2, D3, D4) et chaque commutateur semi-conducteur de puissance (T1, T2) est raccordée électriquement une bobine synchrone (6), la bobine synchrone (6) présentant un premier enroulement (W1) et un deuxième enroulement (W2) raccordé magnétiquement au premier enroulement (W1), le premier enroulement (W1) étant raccordé électriquement entre la borne de commande (G) de chaque commutateur semi-conducteur de puissance (T1, T2) et la cathode de la première diode (D1) ainsi que l'anode de la troisième diode (D3), le deuxième enroulement (W2) étant raccordé électriquement entre la deuxième borne (E) de raccordement de courant de charge de chaque commutateur semi-conducteur de puissance (T1, T2) et l'anode de la deuxième diode (D2) ainsi que la cathode de la quatrième diode (D4).
